# EUROPEAN PATENT APPLICATION

(11) **EP 4 422 359 A1**
(43) Date of publication of application: **28.08.2024**
(21) Application number: 23158343.6
(22) Date of filing: 23.02.2023
(51) Int. Cl.: H05K 1/02, H05K 1/11, H05K 3/34

(54) **CIRCUIT BOARD**

(71) Applicant: Magna Electronics Sweden AB, 447 37 Vårgårda (SE)
(72) Inventor: ROMBO, Lars, 583 30 Linköping (SE); WISEMAN, Michael, 583 30 Linköping (SE)
(74) Representative: Müller Verweyen

(57) **Abstract**

The invention relates to a circuit board (10) with at least one mounting position (11) for a surface mounted component (12), wherein the surface mounted component (12) is a bottom terminated component, wherein the mounting position (11) comprises a central solder pad (13) and multiple solder contacts (14) which are arranged along at least two lines (15) parallel to at least two edges (16) of the central solder pad (13). The central solder pad (13) comprises at least one trench (17), wherein the trench (17) extends into a first corner (18) of the at least two edges (16) of the central solder pad (13).

## Description

The invention relates to a circuit board with at least one mounting position for a surface mounted component according to the preamble of claim 1.

Electronics comprise surface mounted components, such as integrated circuits, that are soldered to a circuit board. A circuit board can be, for example, a printed circuit board (PCB) that enables the connection of multiple electronic components, like surface mounted components (SMC), to be mounted to the circuit board. Typically, the electronic components are soldered to the circuit board. In modern electronics, bottom termination components (BTC) are used, which comprise a large central solder joint that provides the mechanical strength and fixation between the electronic component and the circuit board, as well as a thermal connection to transfer heat away from the electronic component. The central solder pad of the circuit board is therefore also called thermal pad. This connection does not have a visible solder joint, so inspection often relies on x-ray scanning.

A common problem with BTC components, especially with bigger components, is voids in the large central solder joint, reducing the thermal transfer and mechanical strength of the solder joint. Voids are bubbles that form a space in the solder joint, which act as an insulator. These voids occur when the circuit board is heated for curing of the solder paste and can be a result of trapped residual gas in the solder paste or flux that turns to gas, builds up and is trapped during heating. The voids in the central joint on the thermal pad tend to lift the component body, and affect the small signal pads around the edges. The component may tilt, and the distances at the sides may vary. Solder is pulled under the component, when the component is higher. Therefore, the signal leads can become stretched. Furthermore, there is often no visible solder joint to inspect. This results in a potential quality issue, and makes the solder joint very hard to inspect in any automated inspection system. To address the issues of voids, specific requirements are set for the max percentage of void area. Accordingly, in order to provide a sufficient thermal connection and mechanical strength between the BTC components and the circuit board, the void content in the central solder joint must be below a certain limit and is checked by means of x-ray scanning.

From KR10-2009-0123385 air vent lines are formed in the mounting region of the board where the component is bonded are known. Nonetheless, these air vents may cause electrochemical problems with the leads arranged on the side portions of the component.

It is the object of the invention to provide an improved circuit board.

The invention solves this object with the features of the independent claims.

A circuit board with at least one mounting position for a surface mounted component (SMC) is proposed, wherein the surface mounted component (SMC) is a bottom terminated component (BTC). The mounting position comprises a central solder pad and multiple solder contacts or signal leads which are arranged along at least two lines parallel to at least two edges of the central solder pad. It is proposed that the central solder pad comprises at least one trench, wherein the trench extends into a first corner of the at least two edges of the central solder pad.

The invention has recognized that residual of the flux material or soldering paste can contaminate the solder contacts or leads and cause electrochemical problems such as migration and corrosion with the leads of the component connected to the solder contacts of the circuit board. The proposed solution directs any excess flux material away from the central solder pad respectively the central solder joint away from the multiple solder contacts respectively the leads connecting a BTC component to the circuit board. Therefore, any contamination of the leads for input/output of a BTC component can be avoided. However, the content of voids in a central solder joint on the central solder pad or thermal pad of the circuit board can be effectively reduced by means of the at least one trench. As a result, the bond quality and the process stability to a bottom terminated component can be improved with the proposed design of a circuit board.

According to a further development, it is proposed that the at least one trench extends from the central solder pad through an intersection of extensions of the at least two lines of multiple solder contacts.

Thereby, any excess flux material or gas from a central solder joint on the central solder pad is guided further away from the solder contacts or leads.

The multiple solder contacts are preferably on four sides of the central solder pad along four lines, respectively. The extension of these lines cross each other at four intersections.

Preferably, the at least one trench in the central solder pad is in a copper layer of the central solder pad. Accordingly, the walls of the at least one trench in the central solder pad are preferably formed by the copper layer of the central solder pad. The base of the at least one trench in the central solder pad is preferably formed by a fiber reinforced laminate, for example FR-4.

Further preferably, the at least one trench extends from the central solder pad into a solder mask of the circuit board. The walls of the at least one trench extending from the central solder pad are preferably formed by the sold mask of the circuit board. The base of the at least one trench extending from the central solder pad is preferably formed by a fiber reinforced laminate, for example FR-4.

In a preferred embodiment, the at least one trench comprises a copper trench section in the central solder pad and at least one solder mask trench section extending from the central solder pad into the solder mask of the circuit board. Further preferably, the copper trench section is between two solder mask sections. Preferably, the solder mask trench section and the copper trench section have a common base, preferably formed by a fiber reinforced laminate, for example FR-4. Accordingly, a passageway for gaseous components is preferably created on the circuit board by removing parts of the copper layer and parts of the solder mask.

Preferably, the trench extends from the first corner of the at least two edges of the central solder pad to a second corner of the central solder pad, preferably a second corner opposite the first corner.

Accordingly, a large part of the area of the central solder pad is close to the outer edge of the central solder pad and/or close to the trench so that gaseous components can be vented to the corners during the soldering process. The trench preferably extends diagonally through the central solder pad and connects the first and second corners.

It is further preferred that the at least one trench extends from the central solder pad through two different intersections of the extensions of any two lines of said multiple solder contacts.

Thus, the trench preferably extends through both intersections, thereby providing a passageway for gaseous components of the central solder joint beyond the intersection and away from the solder contacts of the mounting position.

It is further proposed that the central solder pad comprises two trenches crossing each other. This allows an effective venting of gas during soldering.

In a preferred embodiment, the base of at least one trench is between 20 *µ*m and 80 *µ*m lower than rest of the surface of the central solder pad. The base of at least one trench is preferably, for example, 50 *µ*m lower than the rest of the surface of the central solder pad. The proposed range of depths allows adequate venting while the impact on the circuit board is limited and negligible.

It is further proposed that the at least one trench is between 150 *µ*m und 250 *µ*m wide. In an advantageous embodiment, the at least one trench is for 200 *µ*m wide, for example. The proposed range of wideness allows suitable venting, avoids bridging the trench and limits the needed area for the trench itself on the central solder pad.

In a preferred embodiment, the central solder pad has a rectangular shape. This shape corresponds to typical bottom terminal components. The multiple solder contacts for input/output signals are preferably arranged on all four sides of the rectangular central solder pad. Preferably, the central solder pad having a rectangular shape comprises two trenches each connecting the two corners at the edges of the central solder pad opposite and crossing each other. Further preferably, the two trenches further extend through four intersections of extensions of any two lines of said multiple solder contacts. Further preferably, the central solder pad has a square shape.

It is further proposed that the circuit board comprises at least one surface mounted component (SMC), wherein the surface mounted component (SMC) is a bottom terminated component (BTC), soldered to the at least one mounting position of the circuit board.

The proposed circuit board has a central solder joint that connects the bottom terminated component to the circuit board. The central solder joint on the proposed central solder pad has a low void content and provides a high reliability.

In a preferred embodiment, the surface mounted component is a quad flat pack (QFN) or a small outline integrated circuit (SOIC) or land grid array (LGA).

In a preferred embodiment, the at least one trench exceeds the corresponding surface mounted component by at least 10 *µ*m, preferably at least 15 *µ*m. This further enhances the venting of gases and excess flux material from the central solder joint without adversely affecting the soldered contacts along the edges of the central solder joint. Preferably, the at least one trench exceeds the corresponding surface mounted component at maximum 50 *µ*m, preferably at maximum 20 *µ*m. Preferably, the circuit board with at least one trench exceeding the corresponding surface mounted component has a solder mask trench section exceeding the component.

In the following the invention shall be illustrated on the basis of preferred embodiments with reference to the accompanying drawings. Therein shows:
- Fig. 1: an x-ray image of a circuit board with a bottom terminated component with a central solder joint with high void content according to the prior art;
- Fig. 2: an x-ray image of a circuit board with a bottom terminated component with a central solder joint with low void content according to the invention;
- Fig. 3: a schematic illustration of the venting during the soldering process;
- Fig. 4: an embodiment of a circuit board with a mounting position for a surface mounted component having one trench; and
- Fig. 5: an embodiment of a circuit board with a mounting position for a surface mounted component having two trenches.

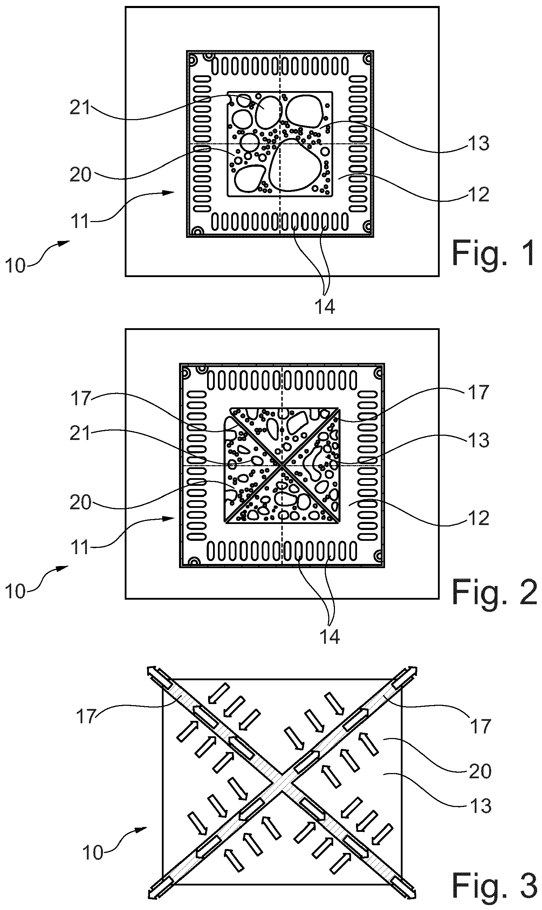

Figure 1 shows a circuit board 10 according to the prior art with a mounting position 11 for a surface mounted component (SMC) 12, wherein the surface mounted component 12 is a bottom terminated component (BTC) that is soldered to the mounting position 11. The mounting position 11 comprises a central solder pad 13 which is also known as thermal pad. The formed central solder joint 20 on the central solder pad 13 provides a thermal and mechanical connection between the surface mounted component 12 and the circuit board 10. The central solder joint 20 in the prior art has a high content of voids 21 due to trapped gas during curing or the soldering process as shown in Figure 1. The high void content reduces the reliability and thermal properties of the formed central solder joint 20 in the prior art.

Figure 2 shows an embodiment of a circuit board 10 having a mounting position 11 for surface mounted component 12, in particular a bottom terminated component, soldered to the mounting position 11 according to the invention. Here, the central solder pad 13 comprises two trenches 17 extending into the four corners 18 formed by the four edges 16 of the central solder pad 13.

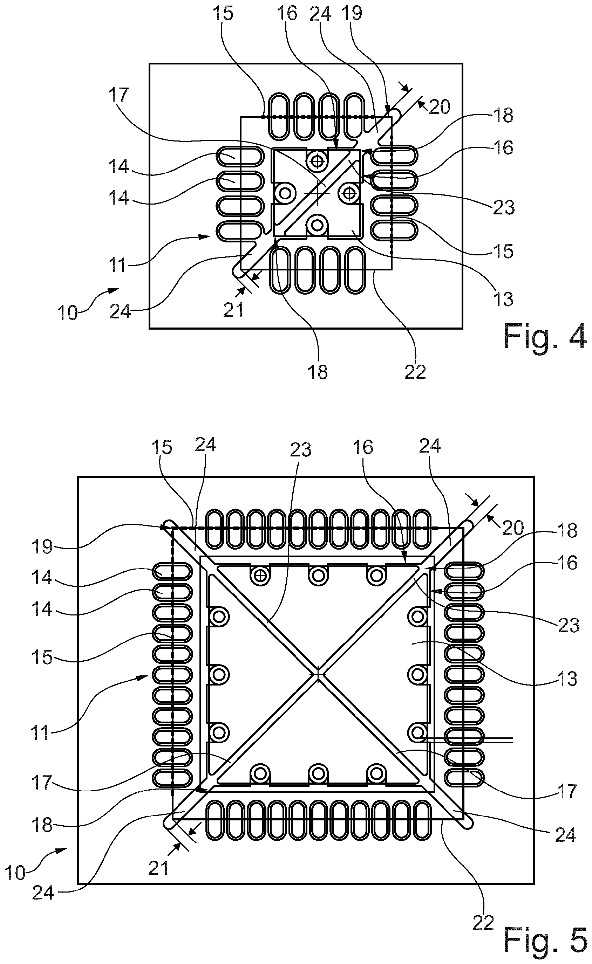

Surrounding the central solder pad 13 are multiple solder contacts 14 that are arranged along four lines 15, see also Figures 4 and 5, parallel to the edges 16 of the central solder pad 13.

The trenches 17 facilitate the venting of gas from the solder material during the process, so that the void content of a central solder joint 20 can be significantly reduced, as shown by comparison of Figure 1 and 2. By venting into the corners 18 of the central solder pad 13, gaseous components, excess flux, and/or solder material dragged along will not reach the solder contacts 14 for the input and output signals of the surface mounted component 12. This improves the quality of the bond between the surface mounted component 12 and the circuit board 10, in particular at the solder contacts 14.

Figure 3 shows a schematic illustration of venting during the soldering process when a central solder joint 20 is formed. Here, the arrows symbolize the gas flow from the solder paste due to the heat input of the soldering process, e.g., reflow soldering. The trenches 17 form a sink for the venting gas and prevent the formation of large voids 21 and generally reduce the void content. In addition, the trenches 17 direct the vent gas to the corners 18. In this way, any negative effect of the vent gas on the solder contacts 14 of the surface mounted device 12 can be avoided.

Figure 4 and 5 illustrate two embodiments of circuit boards 10. The circuit board 10 of Figure 4 comprises a trench 17 extending from a first corner 18 at the upper right to a second corner 18 at the lower left. The trench 17 extends from the central solder pad 13 through both intersections 19 of two lines passing through the solder contacts 14 arranged parallel to the adjacent edge 16 of the central solder pad 13. The trench 17 extends beyond the intersection 19 in this preferred embodiment. Accordingly, the distance of the end of trench 17 from the adjacent solder contacts 14 is further increased.

Figure 4 further shows the outline of a surface mounted component 12 when bonded to the circuit board 11. The trenches 17 terminate preferably outside the outline 22 by at least 10 *µ*m, resulting in an excess 21.

In this preferred embodiment, the trench 17 is 50 *µ*m deep and the wideness 20 is 200 *µ*m. The trench 17 can be formed on the circuit board 10 by an etching process.

The trench 17 in this preferred embodiment comprises two sections. A copper trench section 23 is formed in the central solder pad 13, where the copper layer is removed from the circuit board 10. The copper trench section 23 continues in both directions as solder mask trench sections 24, where the solder mask is removed from the circuit board 10 in order to form a trench 17.

Figure 5 shows another preferred embodiment of a circuit board 10 according to the invention. The central solder pad 13 of the embodiment of Figure 5 comprises two trenches 17 crossing each other in the middle of the central solder pad 13.

The central solder pads 13 of Figure 4 and 5 comprise a rectangular shape, in particular a square shape. The additional features at the central solder pad 13 as shown in Figures 4 and 5 do not contradict the basic rectangular shape in general or the edges 16 of the central solder pad 13.

## Claims

1. Circuit board (10) with
- at least one mounting position (11) for a surface mounted component (12), wherein the surface mounted component (12) is a bottom terminated component, wherein
- the mounting position (11) comprises a central solder pad (13) and multiple solder contacts (14) which are arranged along at least two lines (15) parallel to at least two edges (16) of the central solder pad (13), **characterized in that**
- the central solder pad (13) comprises at least one trench (17), wherein the trench (17) extends into a first corner (18) of the at least two edges (16) of the central solder pad (13).

2. Circuit board (10) according to claim 1, **characterized in that** the at least one trench (17) extends from the central solder pad (13) through an intersection (19) of extensions of the at least two lines (15) of multiple solder contacts (14).

3. Circuit board (10) according to claim 1 or 2, **characterized in that** the at least one trench (17) in the central solder pad (13) is in a copper layer of the central solder pad (13).

4. Circuit board (10) according to any one of the preceding claims, **characterized in that** the at least one trench (17) extends from the central solder pad (13) into a solder mask of the circuit board (10).

5. Circuit board (10) according to any one of the preceding claims, **characterized in that** the at least one trench (17) comprises a copper trench section (23) in the central solder pad (13) and at least one solder mask trench section (24) extending from the central solder pad (13) into the solder mask of the circuit board (10).

6. Circuit board (10) according to any one of the preceding claims, **characterized in that** the trench (17) extends from the first corner (18) of the at least two edges (16) of the central solder pad (13) to a second corner (18) of the central solder pad (13), preferably a second corner (18) opposite the first corner (18).

7. Circuit board (10) according to any one of the preceding claims, **characterized in that** the at least one trench (17) extends from the central solder pad (13) through two different intersections (19) of extensions of any two lines (15) of said multiple solder contacts (14).

8. Circuit board (10) according to any one of the preceding claims, **characterized in that** the central solder pad (13) comprises two trenches (17) crossing each other.

9. Circuit board (10) according to any one of the preceding claims, **characterized in that** the base of at least one trench (17) is between 20 *µ*m and 80 *µ*m lower than rest of the surface of the central solder pad (13).

10. Circuit board (10) according to any one of the preceding claims, **characterized in that** the at least one trench (17) is between 150 *µ*m und 250 *µ*m wide.

11. Circuit board (10) according to any one of the preceding claims, **characterized in that** the central solder pad (13) has a rectangular shape.

12. Circuit board (10) according to any one of the preceding claims, **characterized in that** the circuit board (10) comprises at least one surface mounted component (12), wherein the surface mounted component (12) is a bottom terminated component, soldered to the at least one mounting position (11) of the circuit board (10).

13. Circuit board (10) according to claim 12, **characterized in that** the surface mounted component (12) is a quad flat pack or a small outline integrated circuit or land grid array.

14. Circuit board (10) according to claim 12 or 13, **characterized in that** the at least one trench (17) exceeds the corresponding surface mounted component (12) by at least 10 *µ*m,preferably at least 15 *µ*m.
